# EUROPEAN PATENT APPLICATION

(11) **EP 3 261 135 A1**
(43) Date of publication of application: **27.12.2017**
(21) Application number: 16185249.6
(22) Date of filing: 23.08.2016
(51) Int. Cl.: H01L 31/18, H01L 21/67, C23C 14/58, H01L 31/032, C23C 14/56

(54) **REACTIVE HEAT TREATMENT APPARATUS**

(30) Priority: 22.06.2016 TW 105119630
(71) Applicant: Eterbright Solar Corporation, Miaoli County 351 (TW)
(72) Inventor: Huang, Ting-Hui, 35154 Miaoli County (TW)
(74) Representative: Becker Kurig Straus

(57) **Abstract**

A reactive heat treatment apparatus (200, 300) is provided to treat a thin-film device (211, 311). The reactive heat treatment apparatus (200, 300) includes a furnace pipe (201, 312, 324). The furnace pipe (201, 312, 324) extends in a direction and has a first end (202) and a second end (203). The furnace pipe (201, 312, 324) further includes a high-temperature portion (210, 310), a low-temperature portion (220, 320), and a furnace door (223, 323). The high-temperature portion (210, 310) is disposed close to the second end (203) and configured to receive the thin-film device (211, 311). The low-temperature portion (220, 320) is disposed close to the first end (202) and provided with an airtight configuration (222, 322). The furnace door (223, 323) is disposed close to the first end (202). An inner side wall of the low-temperature portion (220, 320) has a sunken portion (221, 321). A height differential (D) is formed between the sunken portion (221, 321) and an inner side wall of the high-temperature portion (210, 310).

## Description

### FIELD OF THE INVENTION

The present invention relates to a reactive heat treatment apparatus, and more particularly to a reactive heat treatment apparatus used for treating a thin-film device. The reactive heat treatment apparatus has a sunken portion to prevent liquid selenium which is condensed from a gas containing selenium from flowing back.

### BACKGROUND OF THE INVENTION

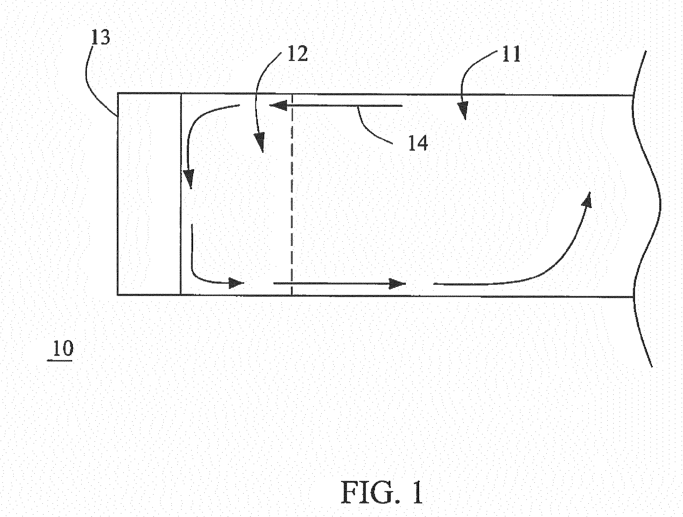

Solar power is renewable and environmentally friendly for the generation of electricity, which does not produce carbon dioxide or other greenhouse gases during the process of solar power generation. These days, people pay attention to environmental protection, so solar power systems are widely applied to residential buildings, public facilities, installation art, and transportation. For converting sunlight into electricity, a solar cell is required to store the electricity converted from sunlight. There are various types of solar cells on the markets. CIGS (copper indium gallium selenide) solar cells have the advantages of better conversion efficiency, good stability, and good low light characteristic. Therefore, CIGS solar cells become one of the mainstream solar cells on the markets. In general, conventional CIGS solar cells are manufactured by sputtering. After Ga/Cu/ln and other elements are sputtered on a Mo metal substrate, a selenization furnace is used for selenization reaction at a high temperature of 450 ~ 550 °C. FIG. 1 is a schematic view of a conventional selenization process. Referring to FIG. 1, in a selenization furnace 10, the temperature of a low-temperature portion 12 near the mouth of the furnace must be maintained below 250 °C, avoiding the degradation of an O-shaped ring to cause an air leak. However, when the gas 14 containing selenium approaches the low-temperature portion 12, the gas 14 containing selenium will be condensed into liquid selenium to flow downward along the furnace wall of the low-temperature portion 12 and flow back to a high-temperature portion 11 along the bottom of the furnace wall. The condensed liquid selenium flowing back to the high-temperature portion 11 is gasified again to be mixed with the gas in the high-temperature portion 11. As a result, the concentration of the gas 14 containing selenium is changed, which influences the stability of the manufacturing process. It is worth for the person skilled in the art to consider how to stabilize the process for manufacturing CIGS solar cells. Accordingly, the inventor of the present invention has devoted himself based on his many years of practical experiences to solve these problems.

### SUMMARY OF THE INVENTION

Based on the above reasons, the present invention is to provide a reactive heat treatment apparatus which can prevent condensed liquid selenium from flowing back to a high-temperature portion so as to keep the stability of selenization reaction and to improve the yield for processing thin-film devices.

According to a first aspect of the present invention, a reactive heat treatment apparatus is provided. The reactive heat treatment apparatus is configured to treat a thin-film device. The reactive heat treatment apparatus comprises a furnace pipe. The furnace pipe extends in a direction and has a first end and a second end. The furnace pipe further includes a high-temperature portion, a low-temperature portion, and a furnace door. The high-temperature portion is disposed close to the second end and configured to receive the thin-film device. The low-temperature portion is disposed close to the first end and provided with an airtight configuration. The furnace door is disposed close to the first end. An inner side wall of the low-temperature portion has a sunken portion, and a height differential is formed between the sunken portion and an inner side wall of the high-temperature portion.

In one embodiment of the present invention, the inner side wall of the low-temperature portion, except the sunken portion, is level with the inner side wall of the high-temperature portion.

In one embodiment of the present invention, the sunken portion extends throughout the low-temperature portion.

In one embodiment of the present invention, the high-temperature portion and the low-temperature portion are made of an identical material.

In one embodiment of the present invention, the high-temperature portion and the low-temperature portion are made of quartz.

In one embodiment of the present invention, the high-temperature portion and the low-temperature portion are parts of a monolithic structure.

In one embodiment of the present invention, the high-temperature portion and the low-temperature portion are made of different materials.

In one embodiment of the present invention, the low-temperature portion is made of stainless steel. The reactive heat treatment apparatus further comprises a container mated with the sunken portion.

In one embodiment of the present invention, the high-temperature portion has a length greater than that of the low-temperature portion.

According to a second aspect of the present invention, a method to manufacture a reactive heat treatment apparatus is provided. The method comprises the steps of: providing a furnace pipe, the furnace pipe extending in a direction, the furnace pipe having a first end and a second end, the furnace pipe including a high-temperature portion and a low-temperature portion, the high-temperature portion being disposed close to the second end and configured to receive a thin-film device, the low-temperature portion being disposed close to the first end and provided with an airtight configuration; and forming a sunken portion on an inner side wall of the low-temperature portion, a height differential being formed between the sunken portion and an inner side wall of the high-temperature portion.

In one embodiment of the present invention, the method further comprises the step of providing a container mated with the sunken portion.

In one embodiment of the present invention, the high-temperature portion has a length greater than that of the low-temperature portion.

In one embodiment of the present invention, the high-temperature portion and the low-temperature portion are made of an identical material.

In one embodiment of the present invention, the high-temperature portion and the low-temperature portion are made of different materials.

In one embodiment of the present invention, the low-temperature portion is made of stainless steel.

According to a third aspect of the present invention, a method to manufacture a reactive heat treatment apparatus is provided. The method comprises the steps of: providing a first furnace pipe; providing a second furnace pipe, the second furnace pipe being provided with an airtight configuration, the first furnace pipe having a length greater than that of the second furnace pipe, the second furnace pipe having a cross-section greater than that of the first furnace pipe; and connecting the first furnace pipe with the second furnace pipe, a height differential being formed at a junction of the first furnace pipe and the second furnace pipe.

In one embodiment of the present invention, the first furnace pipe and the second furnace pipe are made of a stainless steel material.

In one embodiment of the present invention, the first furnace pipe and the second furnace pipe are made of a quartz material.

In one embodiment of the present invention, the first furnace pipe is made of quartz, and the second furnace pipe is made of stainless steel.

### BRIEF DESCRIPTION OF THE DRAWINGS

FIG. 1 is a schematic view of a conventional selenization process;
FIG. 2A is a schematic view of a reactive heat treatment apparatus in accordance with a first embodiment of the present invention;
FIG. 2B is a schematic view of a reactive heat treatment apparatus in accordance with another embodiment of the present invention;
FIG. 3A and FIG. 3B are schematic views of a reactive heat treatment apparatus in accordance with a further embodiment of the present invention;
FIG. 4 is a schematic view of a reactive heat treatment apparatus in accordance with a yet further embodiment of the present invention;
FIG. 5 is a flow chart of a method to manufacture the reactive heat treatment apparatus; and
FIG. 6 is a flow chart of a method to manufacture the reactive heat treatment apparatus of another embodiment.

### DESCRIPTION OF THE PREFERRED EMBODIMENTS

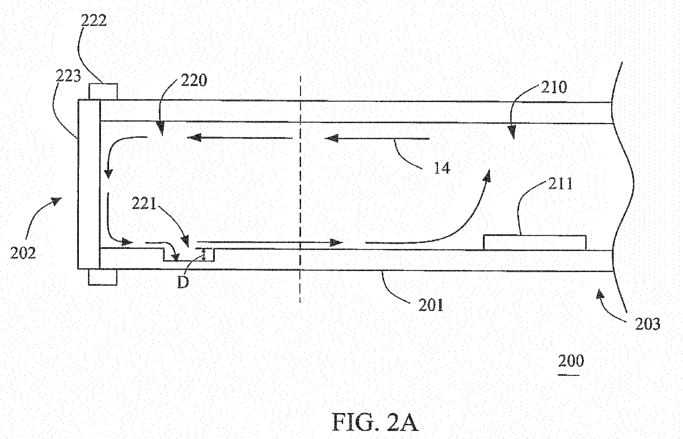

FIG. 2A is a schematic view of a reactive heat treatment apparatus 200 in accordance with a first embodiment of the present invention. The reactive heat treatment apparatus 200 of the present invention is configured to treat a thin-film device 211. The thin-film device 211 in this embodiment is a CIGS (copper indium gallium diselenide) thin-film solar cell. The thin-film device 211 is placed in the reactive heat treatment apparatus 200 to be processed by sputtering. At high temperatures, selenium is deposited on the surface of the thin-film device 211 for selenization reaction.

The reactive heat treatment apparatus 200 comprises a furnace pipe 201. The furnace pipe 201 extends in a direction. The furnace pipe 201 has a first end 202 and a second end 203. The second end 203 is opposite the first end 202. The second end 203 and the first end 202 are disposed at two ends of the furnace pipe 201, respectively. The furnace pipe 201 further includes a high-temperature portion 210 and a low-temperature portion 220. In this embodiment, the high-temperature portion 210 has a length greater than that of the low-temperature portion 220.

The high-temperature portion 210 is disposed close to the second end 203. The high-temperature portion 210 is the area configured to treat the thin-film device 211, so the thin-film device 211 is placed in the high-temperature portion 210. The temperature of the high-temperature portion 210 during processing can be up to 450-550 degrees centigrade, subjecting the thin-film device 211 to selenization reaction in the high-temperature portion 210. During selenization reaction, the gas 14 containing selenium in the furnace pipe 201 flows toward the low-temperature portion 220. The gas 14 containing selenium is a fluid that is a noble gas, such as nitrogen or argon, mixed with a certain proportion of gaseous selenium or selenium compound.

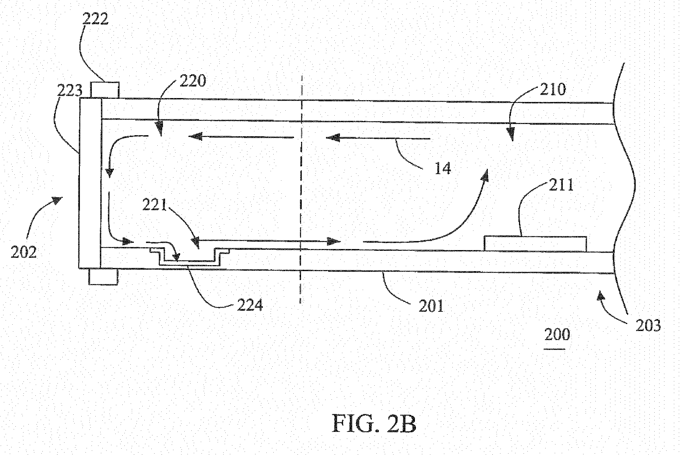

The low-temperature portion 220 is disposed close to the first end 202. The low-temperature portion 220 includes a sunken portion 221, an airtight configuration 222, and a furnace door 223. In this embodiment, the airtight configuration 222 is an O-shaped ring. The low-temperature portion 220 is able to lower the temperature of the gas 14 containing selenium in the furnace pipe 201 to about 250 degrees centigrade or a lower temperature. This can avoid the degradation of the airtight configuration 222 to cause an air leak due to a high temperature. Thus, the low-temperature portion 220 is capable of protecting the airtight configuration 222. The pipe wall or the outer side of the pipe wall of the low-temperature portion 220 may be provided with a cooling device, such as a cooling pipe, to accommodate a cooling fluid for lowering and/or keeping the temperature of the low-temperature portion 220. The sunken portion 221 is disposed on the inner side wall of the low-temperature portion 220. A height differential D is formed between the inner side wall of the sunken portion 221 of the low-temperature portion 220 and the inner side wall of the high-temperature portion 210. When the gas 14 containing selenium flows from the high-temperature portion 210 to the low-temperature portion 220 due to a temperature difference, the gas 14 containing selenium will be condensed because the temperate drops. The condensed selenium flows downward along the pipe wall of the low-temperature portion 220 and accumulates at the bottom of the pipe wall of the low-temperature portion 220 to enter the sunken portion 221. FIG. 2B is a schematic view of a reactive heat treatment apparatus 200 in accordance with another embodiment of the present invention. In this embodiment, the sunken portion 221 is provided with a container 224 mated with the sunken portion 221. The container 224 can be a crucible for storing the liquid selenium condensed from the gas 14 containing selenium. After finishing selenization reaction, the condensed selenium accumulated in the container 224 can be cleaned regularly. The container can be taken out from the sunken portion if necessary, so that the accumulated condensed selenium can be cleaned conveniently.

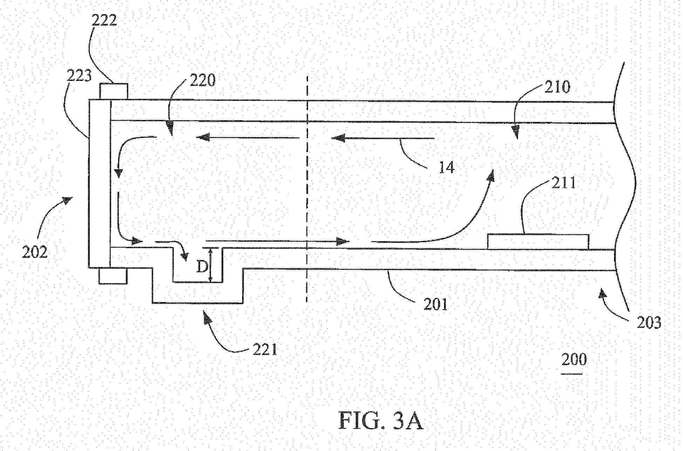

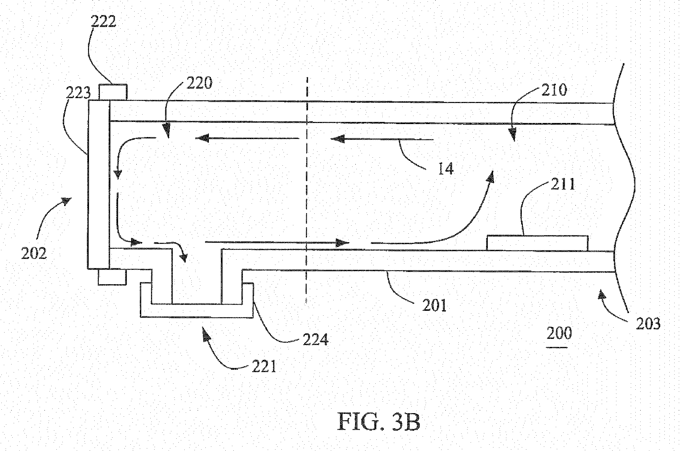

In this embodiment, the inner side wall of the low-temperature portion 220, except the sunken portion 221, is level with the inner side wall of the high-temperature portion 210. Besides, the high-temperature portion 210 and the low-temperature portion 220 are parts of a monolithic structure. Therefore, the high-temperature portion 210 and the low-temperature portion 220 are made of an identical material and formed in one piece. For example, the furnace pipe 201 of the high-temperature portion 210 and the low-temperature portion 220 is a quartz pipe in one piece. The high-temperature portion 210 and the low-temperature portion 220 can be made of different materials and are connected with each other. For example, the high-temperature portion 210 is a quartz pipe and the low-temperature portion 220 is made of a stainless steel material. In addition, the sunken portion 221 is formed on the inner side of the low-temperature portion 220, so the outer diameter of the furnace pipe 201 doesn't be changed. FIG. 3A and FIG. 3B are schematic views of a reactive heat treatment apparatus 200 in accordance with a further embodiment of the present invention. In the embodiment of FIG. 3A, the sunken portion 221 protrudes out of the furnace pipe 201. In the embodiment of FIG. 3B, the container 224 is disposed beneath the sunken portion 221 and mated with the sunken portion 221. The sunken portion 221 can be a closed part, as shown in FIG. 3A, or the sunken portion 221 has an opening, as shown in FIG. 3B, to mate with the container 224.

When the gas 14 containing selenium flows from the high-temperature portion 210 to the low-temperature portion 220 due to a temperature difference, the gas 14 containing selenium will be condensed because the temperate drops. The condensed selenium flows downward along the pipe wall of the low-temperature portion 220 and accumulates at the bottom of the pipe wall of the low-temperature portion 220 to enter the sunken portion 221. That is to say, the gas 14 containing selenium is condensed into liquid selenium and stored in the sunken portion 221 due to cooling, preventing the condensed liquid selenium from flowing back along the bottom of the furnace pipe 201 to the high-temperature portion 210 to be gasified again and change the concentration of the selenium contained in the gas 14 containing selenium in the furnace pipe 201. Therefore, the concentration of the gas 14 containing selenium in the high-temperature portion 210 can be kept constant rendering stable process for treating the thin-film device 211 because the condensed liquid selenium won't flow back to the high-temperature portion 210.

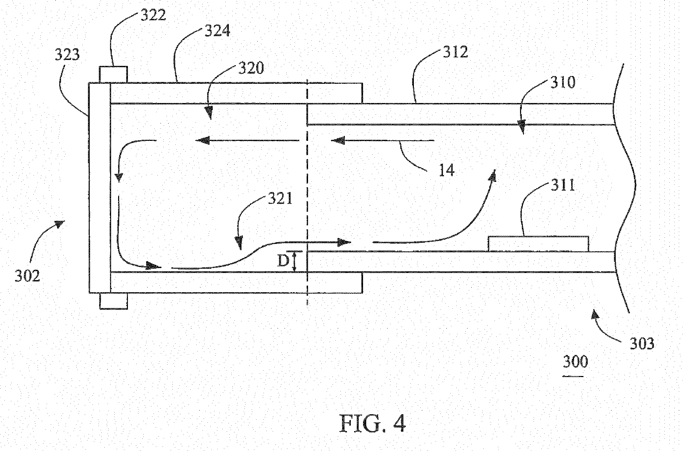

FIG. 4 is a schematic view of a reactive heat treatment apparatus 300 in accordance with a yet further embodiment of the present invention. The reactive heat treatment apparatus 300 of this embodiment comprises a first furnace pipe 312 and a second furnace pipe 324 connected with the first furnace pipe 312. The second furnace pipe 324 has a cross-section greater than that of the first furnace pipe 312. The inside of the second furnace pipe 324 is defined as a low-temperature portion 320. The inside of the first furnace pipe 312 is defined as a high-temperature portion 310. The functions of the high-temperature portion 310 and the low-temperature portion 320 are similar to those of the aforesaid embodiments and won't be described again. The diameter of the first furnace pipe 312 is greater than that of the second furnace pipe 324. After the first furnace pipe 312 and the second furnace pipe 324 are connected together, a sunken portion 321 is formed at the junction of the first furnace pipe 312 and the second furnace pipe 324 because of the diameter difference between the first furnace pipe 312 and the second furnace pipe 324. The sunken portion 321 extends throughout the low-temperature portion 320. The sunken portion 321 is adapted to store the condensed liquid selenium flowing downward along the pipe wall of the low-temperature portion 320, preventing the condensed liquid selenium from flowing back to the high-temperature portion 310. In this embodiment, the first furnace pipe 312 and the second furnace pipe 324 are made of an identical material, such as quartz pipes or stainless steel pipes to be connected together. The first furnace pipe 312 and the second furnace pipe 324 can be made of different materials. For instance, the first furnace pipe 312 is made of quartz and the second furnace pipe 324 is made of stainless steel. In some embodiments, the first furnace pipe 312 is made of stainless steel and the second furnace pipe 324 is made of quartz.

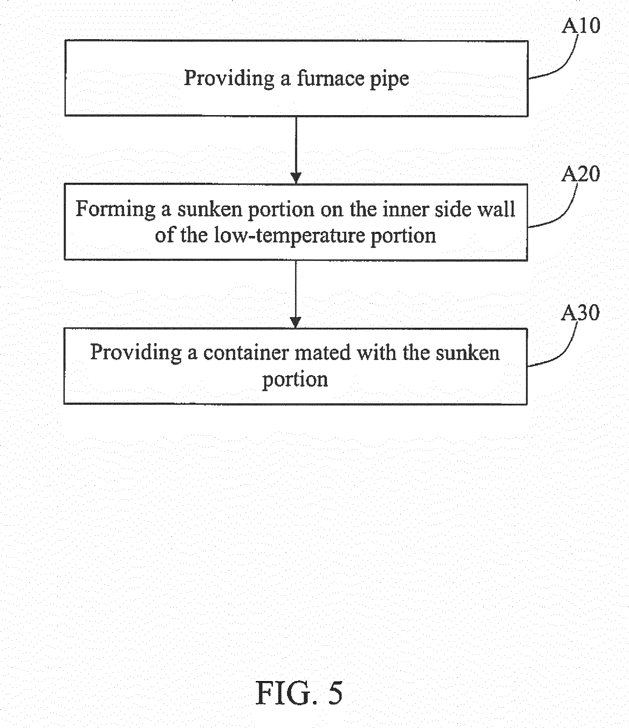

FIG. 5 is a flow chart of a method to manufacture the reactive heat treatment apparatus 200 of FIG. 2A and FIG. 2B. Referring to FIG. 5, FIG. 2A and FIG. 2B, a furnace pipe 201 is provided (step A10). The furnace pipe 201 extends in a direction. The furnace pipe 201 has a first end 202 and a second end 203. The furnace pipe 201 further includes a high-temperature portion 210 and a low-temperature portion 220. The high-temperature portion 210 is disposed close to the second end 203 and configured to receive a thin-film device 211. The low-temperature portion 220 is disposed close to the first end 202. The low-temperature portion 220 is further provided with an airtight configuration 222. In some embodiments, the high-temperature portion 210 has a length greater than that of the low-temperature portion 220. A sunken portion 221 is formed on the inner side wall of the low-temperature portion 220 (step A20). A height differential is formed between the sunken portion 221 and the inner side wall of the high-temperature portion 210. In some embodiments, the sunken portion 221 is provided with a container 224 mated with the sunken portion 221. The container 224 can be a crucible for storing the condensed selenium dropped in the low-temperature portion 220. Besides, in this embodiment, the low-temperature portion 220 is made of stainless steel. In different embodiments, the low-temperature portion 220 and the high-temperature portion 210 are made of an identical material, or they can be made of different materials.

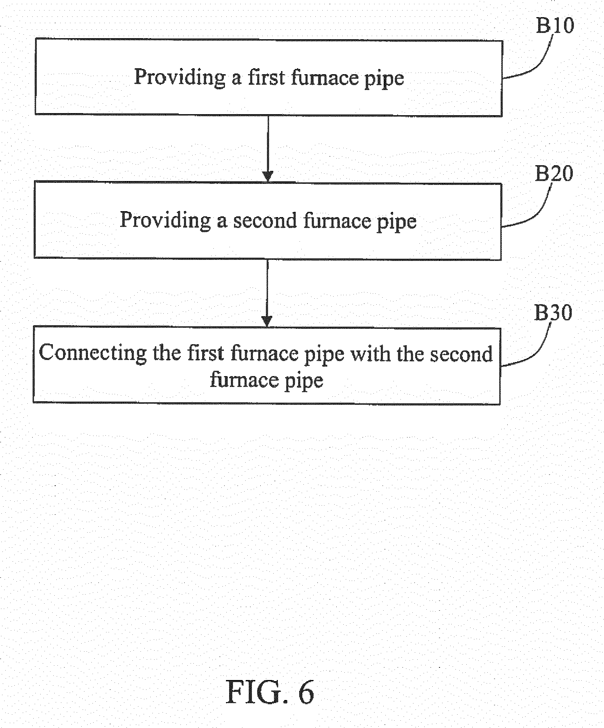

FIG. 6 is a flow chart of a method to manufacture the reactive heat treatment apparatus 300 of FIG. 4. Referring to FIG. 6 and FIG. 4, a first furnace pipe 312 is provided (step B10). The first furnace pipe 312 is configured to form a high-temperature portion 310 and adapted to treat a thin-film device 311. A second furnace pipe 324 is provided (step B20). The second furnace pipe 324 is further provided with an airtight configuration 322. The second furnace pipe 324 is configured to form a low-temperature portion 320. The low-temperature portion 320 is capable of protecting the airtight configuration 322. The first furnace pipe 312 has a length greater than that of the second furnace pipe 324. The second furnace pipe 324 has a cross-section greater than that of the first furnace pipe 312. The step B10 can be interchanged with the step B20.

After that, the first furnace pipe 312 and the second furnace pipe 324 are connected together (step B30). For example, they are connected by sintering. Because the cross-section of the second furnace pipe 324 is greater than that of the first furnace pipe 312, a height differential D (as shown in FIG. 4) is formed at the junction of the first furnace pipe 312 and the second furnace pipe 324. The height differential D is to form a sunken portion 321. The sunken portion 321 is adapted to store the condensed liquid selenium of the low-temperature portion 320. The height differential D can block the condensed liquid selenium from flowing back to the high-temperature portion 310. Therefore, the concentration of the gas in the high-temperature portion 310 can be kept constant for processing selenization reaction stably.

In this embodiment, the reactive heat treatment apparatus 300 is formed by connecting the first furnace pipe 312 with the second furnace pipe 324. The first furnace pipe 312 and the second furnace pipe 324 can be made of an identical material or different materials. For instance, the first furnace pipe 312 is made of a quartz material and the second furnace pipe 324 is made of a stainless steel material. In another embodiment, both the first furnace pipe 312 and the second furnace pipe 324 are made of a stainless steel material. In a further embodiment, both the first furnace pipe 312 and the second furnace pipe 324 are made of a quartz material. A person skilled in this field can know that the materials of the first furnace pipe 312 and the second furnace pipe 324 can be changed according to the design of the reactive heat treatment apparatus 300.

The low-temperature portion 220, 320 of the reactive heat treatment apparatus 200, 300 of the present invention is provided with the sunken portion 221, 321. When the gas 14 containing selenium flows from the high-temperature portion 210, 310 to the low-temperature portion 220, 320 due to a temperature difference, the gas 14 containing selenium will be condensed because the temperate drops. The condensed selenium flows downward along the pipe wall of the low-temperature portion 220 and accumulates at the bottom of the pipe wall of the low-temperature portion 220 to enter the sunken portion 221, 321. The condensed liquid selenium won't flow back along the furnace pipe 203, 303 to the high-temperature portion 210, 310. Therefore, the concentration of the gas 14 containing selenium in the high-temperature portion 210, 310 can be kept constant. The arrangement of the sunken portion 221, 321 can greatly enhance the stability for treating the thin-film device.

Although particular embodiments of the present invention have been described in detail for purposes of illustration, various modifications and enhancements may be made without departing from the spirit and scope of the present invention. Accordingly, the present invention is not to be limited except as by the appended claims.

## Claims

1. A reactive heat treatment apparatus (200, 300) configured to treat a thin-film device (211, 311), comprising:
a furnace pipe (201, 312, 324), the furnace pipe (201, 312, 324) extending in a direction and having a first end (202) and a second end (203), the furnace pipe (201, 312, 324) further including:
a high-temperature portion (210, 310), the high-temperature portion (210, 310) being disposed close to the second end (203) and configured to receive the thin-film device (211);
a low-temperature portion (220, 320), the low-temperature portion (220, 320) being disposed close to the first end (202) and provided with an airtight configuration (222, 322); and
a furnace door (223, 323), the furnace door (223, 323) being disposed close to the first end (202);
wherein, an inner side wall of the low-temperature portion (220, 320) has a sunken portion (221, 321), and a height differential (D) is formed between the sunken portion (221, 321) and an inner side wall of the high-temperature portion (210, 310).

2. The reactive heat treatment apparatus (200) as claimed in claim 1, wherein the inner side wall of the low-temperature portion (220), except the sunken portion (221), is level with the inner side wall of the high-temperature portion (210).

3. The reactive heat treatment apparatus (300) as claimed in claim 1, wherein the sunken portion (321) extends throughout the low-temperature portion (320).

4. The reactive heat treatment apparatus (200, 300) as claimed in any one of claims 1-3, wherein the high-temperature portion (210, 310) and the low-temperature portion (220, 320) are made of an identical material.

5. The reactive heat treatment apparatus (200, 300) as claimed in claim 4,
wherein the high-temperature portion (210, 310) and the low-temperature portion (220, 320) are made of quartz; or
wherein the high-temperature portion (210, 310) and the low-temperature portion (220, 320) are parts of a monolithic structure.

6. The reactive heat treatment apparatus (200, 300) as claimed in any one of claims 1-3,
wherein the high-temperature portion (210, 310) and the low-temperature portion (220, 320) are made of different materials; or
wherein the low-temperature portion (220, 320) is made of stainless steel.

7. The reactive heat treatment apparatus (200) as claimed in claim 1, further comprising a container (224) mated with the sunken portion (221).

8. The reactive heat treatment apparatus (200, 300) as claimed in any one of claims 1-7, wherein the high-temperature portion (210, 310) has a length greater than that of the low-temperature portion (220, 320).

9. A method to manufacture a reactive heat treatment apparatus (200), comprising the steps of:
providing a furnace pipe (201), the furnace pipe (201) extending in a direction, the furnace pipe (201) having a first end (202) and a second end (203), the furnace pipe (201) including a high-temperature portion (210) and a low-temperature portion (220), the high-temperature portion (210) being disposed close to the second end (203) and configured to receive a thin-film device (211), the low-temperature portion (220) being disposed close to the first end (202) and provided with an airtight configuration (222); and
forming a sunken portion (221) on an inner side wall of the low-temperature portion (220), a height differential (D) being formed between the sunken portion (221) and an inner side wall of the high-temperature portion (210).

10. The method to manufacture a reactive heat treatment apparatus (200) as claimed in claim 9, further comprising the step of providing a container (224) mated with the sunken portion (221).

11. The method to manufacture a reactive heat treatment apparatus (200) as claimed in claim 9 or 10, wherein the high-temperature portion (210) has a length greater than that of the low-temperature portion (220).

12. The method to manufacture a reactive heat treatment apparatus (200) as claimed in any one of claims 9-11,
wherein the high-temperature portion (210) and the low-temperature portion (220) are made of an identical material; or
wherein the high-temperature portion (210) and the low-temperature portion (220) are made of different materials.

13. The method to manufacture a reactive heat treatment apparatus (200) as claimed in any one of claims 9-12, wherein the low-temperature portion (220) is made of stainless steel.

14. A method to manufacture a reactive heat treatment apparatus (300), comprising the steps of:
providing a first furnace pipe (310);
providing a second furnace pipe (320), the second furnace pipe (320) being provided with an airtight configuration (322), the first furnace pipe (310) having a length greater than that of the second furnace pipe (320), the second furnace pipe (320) having a cross-section greater than that of the first furnace pipe (310); and
connecting the first furnace pipe (310) with the second furnace pipe (320), a height differential (D) being formed at a junction of the first furnace pipe (310) and the second furnace pipe (320).

15. The method to manufacture a reactive heat treatment apparatus (300) as claimed in claim 14,
wherein the first furnace pipe (310) and the second furnace pipe (320) are made of a stainless steel material; or
wherein the first furnace pipe (310) and the second furnace pipe (320) are made of a quartz material; or
wherein the first furnace pipe (310) is made of quartz, and the second furnace pipe (320) is made of stainless steel.
